# EUROPEAN PATENT SPECIFICATION

(11) **EP 4 244 976 B1**
(45) Date of publication and mention of the grant of the patent: **01.01.2025**
(21) Application number: 21811319.9
(22) Date of filing: 15.11.2021
(51) Int. Cl.: H02P 29/024, G01N 35/00, H02P 29/032, H02P 3/06

(54) **MONITORING DEVICE FOR MONITORING AN ELECTRIC MOTOR IN A LABORATORY SYSTEM**
ÜBERWACHUNGSVORRICHTUNG ZUR ÜBERWACHUNG EINES ELEKTROMOTORS IN EINEM LABORSYSTEM
DISPOSITIF DE SURVEILLANCE POUR SURVEILLER UN MOTEUR ÉLECTRIQUE DANS UN SYSTÈME DE LABORATOIRE

(30) Priority: 16.11.2020 EP 20207857
(43) Date of publication of application: 20.09.2023
(73) Proprietor: Roche Diagnostics GmbH, 68305 Mannheim (DE); F. Hoffmann-La Roche AG, 4070 Basel (CH)
(72) Inventor: BERBERICH, Walter, 71636 Ludwigsburg (DE)
(74) Representative: Altmann Stößel Dick Patentanwälte PartG mbB
(86) International application number: PCT/EP2021/081615
(87) International publication number: WO 2022/101460

(56) References cited:
- EP-A1- 3 056 320
- EP-A1- 3 681 035
- JP-A- 2011 151 890
- RU-C1- 2 107 234
- US-A1- 2017 257 054
- US-A1- 2019 085 924

## Description

### Technical Field

The present invention refers to a monitoring device for monitoring an electric motor and to a laboratory system for performing at least one laboratory task. Further, the present invention refers to a method of monitoring an electric motor and to a method of operating a laboratory system. Further proposed are a computer program and a computer-readable storage medium for performing the method of monitoring an electric motor and a computer program and a computer-readable storage medium for performing the method of operating a laboratory system. The devices, methods, computer programs and storage media specifically may be used in analytical, medical or chemical laboratories, such as for qualitatively or quantitatively analyzing biological samples, e.g. at high throughput. Other fields of application of the present invention, however, are feasible.

### Background art

In the field of analytical, medical or chemical laboratories, automated analyzers are frequently used for analyzing large numbers of samples at high throughput. Exemplary embodiments of automated analyzers, are shown e.g. in WO 2015/011274 A2, in EP 3056320 A1 or in EP 3412603 A1.

Automated analyzers, in the following also referred to as laboratory systems, without excluding alternative embodiments, specifically may be configured for determining one or more analytes in the samples and/or for determining other characteristic properties of a large number of samples in automated fashion and at high throughput, specifically without or with minimized human action. As an example, the samples may comprise biological samples, such as bodily fluids. The laboratory systems typically comprise one or more devices for sample manipulation, such as sample transport devices or the like. Generally, automated analyzers may comprise a plurality of electrical motors for driving the various functions of the analyzers. Generally, however, moving parts of electric motors are subject to wear and tear. In many cases, wear of the electric motor is one of the limiting factors affecting the lifetime of electric motors and, thus, requires maintenance of the laboratory systems.

Generally, devices and methods for monitoring the function of electric motors are known. As an example, EP 2 375 560 A2 describes a device having a motor which comprises a rotor and a stator, and a motor controller for controlling the motor. An encoder and a position regulating module supply an actual signal during operation. The controller has a transformation module that separates actual motor-phase current into a slip portion and a full load portion. Slip and full load controlling modules provide rotor-phase currents for commutating the motor, such that difference between the slip portion and a reference value and the difference between the full load portion and another reference value are minimum. Further, a method of controlling a motor is also disclosed.

CN 208046394 U discloses a monitoring system for direct monitoring of brush wear of a direct current motor. The monitoring system includes a motor commutator, a brush yoke, a brush holder and a brush, wherein the brush holder is fixed on the brush yoke, wherein the brush is arranged in the brush holder, wherein the motor commutator is arranged below the brush holder and wherein the brush is in contact with the motor commutator. The monitoring system further includes: a travel switch, wherein the travel switch is arranged on the upper side of the brush holder; an external control circuit, which includes a power supply, wherein the travel switch is connected in series with the external control circuit; and an alarm device, wherein the alarm device is connected in series with the external control circuit. When a predetermined height of the brush because of wearing and tearing is reached, the travel switch, which is normally open, will be closed to make the external control circuit communicate with the alarm device, which can send a warning that reminds an operator to change the brush.

CN 106443451 A describes a method for checking direct current motor service life. The checking method comprises the following steps: step A: acquiring test motors, dividing the test motors into two groups; step B: conducting increased load test for one group, increasing the load, conducting the simulation based on 1.2 times of the rated current, at this time, a torque adjustment screw needs to be adjusted to make the motor reach the corresponding current, thereby realizing a simulation of effects caused by motor overload conditions to the motor service life; step C: increasing the voltage of another motor group to 1.2 times of the rated voltage, raising up the motor RPM to simulate the effects caused by the motor high speed rotation to the motor service life; step D: dissembling the motors passing the tests in step B and C, determining whether the motor service life meets the requirement. US 6,559,571 B1 describes a brush system for a commutated DC motor. As the brush wears, different cross-sectional shapes, at different positions, come into contact with the commutator. The center of contact for each cross-sectional shape can be different, thereby changing brush angle as wear occurs. The change in brush angle can be desirable, in order to offset other effects which occur as a result of wear. For example, motor speed can change as a result of brush wear. Changing brush angle can offset the change in speed.

WO 2011/117293 A2 and EP 2 550 451 B1 disclose a pitch drive device capable of emergency operation for adjusting a rotor blade pitch of a wind or water power plant. The pitch drive device comprises an inverter device and a three-phase current drive motor. The drive motor is implemented as a three-phase IPM synchronous motor (Interior Permanent Magnet). A direct current power storage device can advantageously be substantially directly connected to an intermediate direct current circuit, at least for emergency operation, between a rectifier device and the inverter device for at least briefly supplying power to the synchronous motor, so that the IPM synchronous motor can be operated at least briefly under speed control when the intermediate circuit voltage UZK is falling. The invention enables speed-controlled emergency operation of the pitch drive device at high torque when an intermediate circuit voltage UZK is falling in emergency operation, wherein the direct current energy storage device can, for example, improve the efficiency as an energy buffer, and reduce current transfer via the rotor slip ring.

EP 0 025 575 A1 describes a dosing device for small amounts of liquid in the milliliter and microliter range having a piston-cylinder system driven by a DC motor. The piston stroke is measured with an optical path length measuring system. For this purpose, a transparent pulse ruler with a regular grating is attached to the piston. The light from a light transmitter falls through the pulse ruler and a fixed scanning plate, which also has a regular grating, onto a light receiver. The pulses from the light receiver are digitized in a pulse preparation system and fed to a counter that can be preset using a coding switch. The counter status influences braking and speed control in such a way that, regardless of the set target speed, the motor speed is reduced to a low value when the end value is approached. As soon as the preset volume has been dosed and the counter has reached zero, the motor is abruptly shut down using a counter voltage via a motor control logic. During the shutdown, the no-load voltage of the motor is measured at regular intervals with the aid of a zero voltage comparator. The piston stroke speed is measured and controlled with the help of pulse monitoring and the motor is also switched off in the event of a mechanical defect. The motor and electronics are powered by batteries or accumulators, which can be charged using a power supply unit.

JP S56-125993 A describes a control circuit of a DC motor connected to a mechanical system having a load abruptly varying with low intrinsic vibration frequency. The control circuit provides a gain compensator to which the output from a speed feedback detector is provided. The output from the detector is inputted to a subtractor provided in the next stage of a proportional compensator of a speed control system. When the speed of the DC motor is lower than the rated value, the compensator will not produce an output. When it exceeds the rated value, it produces an output proportional to the value exceeded to increase the speed feedback amount. Thus, the response speed of the automatic speed control system is equivalently raised to eliminate the overspeed state of the DC motor at the time of impact rise of the load or the like.

US 5,280,222 A discloses a brushless direct current motor being energized by a power stage. Switches of the power stage are selectively switched by an electronic control device. In order to determine the correct commutation pattern, without using rotor position indicators such as Hall-effect devices, the control device is arranged to sample the power fed to the motor. The samples, each responsive to a test signal or normal energization pulses received by the motor, in an ordered sequence define an analogue function whose parameters can be determined by mathematical analysis. The analysis applied to the samples derives the necessary commutation information and the energization signals in a rapid manner by employing a vector or complex number addition based on functions dependent on variable inductance in the operation of the motor.

DE 10 2019 107 876 A1 describes a starter for starting an engine, a commutator for a motor of the starter, and the formation of a graphite coating layer on a surface of the commutator.

WO 1993/018356 A1 describes control systems of air-conditioning systems. Superheat of cooling agent is maintained at first preset level when compressor is working at constant speed and is increased to second higher preset level when compressor is accelerated. The system is also used for estimation of degree of wear of compressor through measurement and comparison of power supplied to compressor and degree of change in temperature or pressure of cooling agent in compressor between initial and subsequent period. The system is also used for distinguishing wear of drive part from wear of part of compressor used for creating pressure.

EP 3 681 035 A1 discloses an AC electric motor monitoring device. The monitoring device monitors an AC electric motor which is driven using a drive power supply. It is characterized by converting a current detection value detected by a current detection means of the AC electric motor to a DC amount and outputting a feature amount on the basis of the DC amount.

JP 2011 151890 A describes a device and a method for detecting wear of a brush, including: a detector for detecting an acceleration of the number of rotations of a rotor of a generator; a calculator for calculating the wear amount of the brush of the generator based on the acceleration of the number of rotations; and a determiner for determining the wearing state based on the wear amount.

US 2019/085924 A1 discloses a method for monitoring the performance of a mechanical brake for a linear electromagnetic motor. The linear motor has a linearly moveable output shaft. The method comprises monitoring travel of the output shaft over the duration of actuation of the mechanical brake and comparing said travel with a predetermined travel threshold.

US 2017/257054 A1 describes a rotary electric machine control system including a rotary electric machine, a rotation speed sensor, a temperature sensor, and circuitry. The rotary electric machine includes a rotor. The rotation speed sensor is to detect a rotation speed of the rotor. The temperature sensor is to detect a temperature of the rotary electric machine. The circuitry is configured to classify an operation time during which the rotor rotates based on the rotation speed detected by the rotation speed sensor and the temperature detected by the temperature sensor. The circuitry is configured to calculate a fatigue degree of the rotor based on the operation time classified. The circuitry is configured to limit the rotation speed of the rotor or output a signal to a user when the fatigue degree exceeds a threshold value.

Despite the advantages achieved by the known method and devices, several technical challenges remain, specifically in the field of electric motors used for driving and manipulating devices in laboratory systems, specifically automated analyzers. Specifically, there is a need for an *in situ* monitoring of the electric motors, providing a current assessment of a state of the electric motors, specifically with respect to wearing of the electric motor's components. In many cases, detecting a wearing status of components of the electric motors, such as commutators and/or brushes, as well as failures such as breaking of windings, winding short circuit and/or harmful operating conditions is technically challenging.

Further, most of the known methods and devices are unsuited for *in situ* measurements, since these methods and devices require interruptions of operation, in order to perform specific tests. These tests typically require operation of the electric motors under testing conditions, and typically monitor the driving conditions required for achieving these testing conditions. Thus, as outlined above, WO 1993/018356 A1 describes a method of estimating the degree of wear of a compressor through measurement and comparison of power supplied to compressor, in order to achieve a specific, constant speed. For these tests, typically, operation of the system has to be interrupted which, specifically in high-throughput laboratory systems, is highly unwanted.

Specifically in laboratory systems, downtimes due to maintenance and motor failures are to be avoided. Many maintenance procedures simply are of reactive nature rather than preplanning. Thus, once a motor failure occurs, spare parts have to be ordered, leading to downtimes of the entire laboratory system. Alternatively, various types of spare parts have to be kept on stock in the laboratory, in order to reduce downtimes, which generally increases costs for operating the laboratory.

### Problem to be solved

It is therefore desirable to provide devices and methods which at least partially address the above-mentioned technical challenges of monitoring electric motors, specifically in laboratory systems. Specifically, devices and methods shall be proposed which allow monitoring the current status of electric motors in a simple and preplanning way.

### Summary

The invention is defined in the independent apparatus claim 1 and independent method claim 10. The preferred embodiments are defined in the dependent claims.

This problem is addressed by a monitoring device for monitoring an electric motor, by a laboratory system comprising the monitoring device, by a method of monitoring an electric motor, by a method of operating a laboratory system, with the features of the independent claims. Further, computer programs and computer-readable storage media are proposed, for performing the methods. Advantageous embodiments which might be realized in an isolated fashion or in any arbitrary combinations are listed in the dependent claims as well as throughout the specification.

As used in the following, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, it shall be noted that the terms "at least one", "one or more" or similar expressions indicating that a feature or element may be present once or more than once typically will be used only once when introducing the respective feature or element. In the following, in most cases, when referring to the respective feature or element, the expressions "at least one" or "one or more" will not be repeated, non-withstanding the fact that the respective feature or element may be present once or more than once.

Further, as used in the following, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

In a first aspect of the present invention, a monitoring device for monitoring an electric motor, specifically of a laboratory system, is disclosed. The monitoring device comprises:
A. at least one receiving unit configured for receiving information on at least one amount of acceleration energy required for accelerating the electric motor from at least one first motion state to at least one second motion state;
B. at least one evaluation unit configured for evaluating the information on the amount of acceleration energy and for determining at least one item of information on a wearing status of the electric motor.

The term "monitoring" as used herein is a broad term and is to be given its ordinary and customary meaning to a person of ordinary skill in the art and is not to be limited to a special or customized meaning. The term specifically may refer, without limitation, to a process, specifically an automated process, of continuously, discontinuously or periodically receiving and/or acquiring data, specifically data describing the status of a device or a system. The term may further comprise deriving secondary information from the data. Specifically, the process of monitoring may be performed without interaction of a user or operator. For this purpose, the monitoring may comprise generating and optionally evaluating one or more measurement signals, wherefrom the desired information may be determined. The measurement signals may be recorded within fixed or variable time intervals or, alternatively or in addition, at an occurrence of at least one pre-specified event.

The term "monitoring device" as used herein is a broad term and is to be given its ordinary and customary meaning to a person of ordinary skill in the art and is not to be limited to a special or customized meaning. The term specifically may refer, without limitation, to a device configured for determining or monitoring a status of another device or system. Specifically, the monitoring device may be configured for performing at least one function selected from the group consisting of monitoring, controlling, surveilling, testing and checking the other device or system, specifically the electric motor. Specifically, the device may comprise a plurality of interacting components, wherein one or more components comprised by the monitoring device may interact with each other to perform the at least one function. The components of the monitoring device may be handled independently from each other or may be coupled or connectable. The monitoring device, specifically one or more of the components of the monitoring device, may be independent from the device or system to be monitored, such as the electric motor. Thus, the monitoring device, in the present case of monitoring the electric motor, may generally be embodied as a device being separate from the electric motor, such as configured for being handled independently from the electric motor. As an example, the monitoring device may be separate from the electric motor itself and/or from a motor control unit. Other embodiments, however, are also feasible, such as by fully or partially integrating the monitoring device into the electric motor and/or into the motor control unit.

In the context of the electric motor, the monitoring of the electric motor specifically may comprise monitoring one or more parameters describing a status, specifically a current status, of the electric motor. For this purpose, the monitoring may comprise acquiring data, specifically generating measurement signals, specifically electric measurement signals, representative for the one or more parameters describing the status of the electric motor. As will be described in further detail below, as proposed herein, the monitoring of the electric motor may comprise receiving data on the amount of acceleration energy and evaluating the received data in order to derive the desired information.

The term "electric motor" as used herein is a broad term and is to be given its ordinary and customary meaning to a person of ordinary skill in the art and is not to be limited to a special or customized meaning. The term specifically may refer, without limitation, to a device configured for converting electrical energy into kinetic energy and, alternatively or additionally, for converting kinetic energy into electrical energy, e.g. by recuperation. The electric motor may be a direct current (DC) electric motor and/or an alternating current (AC) electric motor. Generally, various types of electric motors may be used herein. As an example, the electric motor may comprise at least one stator configured for generating at least one magnetic field. The electric motor may further comprise at least one rotor, wherein the rotor may comprise one or more conductors for carrying electric currents. The rotor of the electric motor may comprise at least one commutator, wherein the commutator may be electrically coupled to an electric energy source via one or more electrically conducting brushes. The commutator may be configured for reversing an electric current flowing through the rotor upon rotating in the magnetic field generated by the stator. The brushes may be stationary arranged at the stator of the electric motor. However, other types of electric motors may also be feasible, such as brushless electric motors, externally commutated electric motors or the like. The electric motor may form part of a laboratory system as will be outlined in further detail below.

As outlined above, the monitoring device comprises the at least one receiving unit configured for receiving information on the at least one amount of acceleration energy required for accelerating the electric motor from the at least one first motion state to the at least one second motion state. The information may comprise at least one item of information, such as at least one measurement signal and/or data describing the amount of acceleration energy. Examples will be given below.

The term "receiving unit" as used herein is a broad term and is to be given its ordinary and customary meaning to a person of ordinary skill in the art and is not to be limited to a special or customized meaning. Specifically, the term "receiving", as used herein, also is a broad term and is to be given its ordinary and customary meaning to a person of ordinary skill in the art and is not to be limited to a special or customized meaning. The term "receiving" specifically may comprise any type of directly or indirectly taking possession of an object, including information, such as by at least one of acquiring, measuring, determining, receiving from an external source, receiving via an interface or the like. The term "receiving unit" specifically may refer, without limitation, to at least one electronic device configured for receiving the information on the amount of acceleration energy or any indication thereof. The term "receiving information" may refer to the process of acquiring the information, such as by measurement, and/or to the process of obtaining the information from other sources, such as via an interface, from a data storage device or the like. Specifically, the receiving unit may be or may comprise one or more electronic components which may be combined in one single unit or, alternatively or additionally, may be separated from each other in a plurality of units. The electronic components may be configured for interacting with each other in order to perform at least one task of the receiving unit. Specifically, the receiving unit may be configured for directly acquiring the information on the amount of acceleration energy, such as by measuring the amount of acceleration energy. Additionally or alternatively, the receiving unit may be configured for indirectly receiving the information on the amount of acceleration energy, such as by receiving the information via an interface or from another device and/or by determining an indication of the amount of acceleration energy, such as a voltage, a current or a power, i.e. at least one indication which allows deriving the amount of acceleration energy therefrom.

Consequently in summarizing, the term "receiving information on at least one amount of acceleration energy" specifically may refer, without limitation, to one or more of determining the information on the amount of acceleration energy, measuring the amount of acceleration energy, obtaining an item of information on the amount of acceleration energy or determining an indication of the amount of acceleration energy. Specifically, the term "receiving" as used in this context may refer to an active process of quantitatively determining and/or measuring the amount of acceleration energy, thereby deriving the information on the acceleration energy. Additionally or alternatively, the term "receiving" may refer to a passive process of obtaining at least one item of information on the amount of acceleration energy, such as obtaining at least one item of quantitative information on the amount of acceleration energy, for example from another additional device.

The term "information on an amount of acceleration energy" as used herein is a broad term and is to be given its ordinary and customary meaning to a person of ordinary skill in the art and is not to be limited to a special or customized meaning. The term specifically may refer, without limitation, to at least one item of information describing a difference in kinetic energy between the first motion state of the electric motor and the second motion state of the electric motor. The item of information may directly be or may comprise an energy representing said difference in kinetic energy or may be or may comprise any other item of information from which said difference in kinetic energy may be derived by further steps, such as at least one measurement signal on measurement value representing said difference in kinetic energy, e.g. a digital and/or an analogue measurement signal which may be transformed by appropriate algorithms into the difference in kinetic energy. The acceleration generally may be positive or negative, and, thus, may comprise an increase or a decrease in kinetic energy. The amount of acceleration energy, thus, may comprise a positive difference in kinetic energy or a negative difference in kinetic energy, depending on the kinetic energy of the first motion state being higher or lower than the kinetic energy of the second motion state. The amount of acceleration energy may comprise an acceleration energy required for positively accelerating the electric motor and/or for negatively accelerating the electric motor, also referred to as "decelerating" the electric motor.

The term "motion state" as used herein is a broad term and is to be given its ordinary and customary meaning to a person of ordinary skill in the art and is not to be limited to a special or customized meaning. The term specifically may refer, without limitation, to a characteristic of the electric motor being in motion and/or in operation. The motion state of the electric motor may be described qualitatively and/or quantitatively, such as by a numerical indication of a quantity of motion. Specifically, the motion state of the electric motor may be characterized by the at least one quantity of motion selected from the group consisting of: a speed of rotation; a rotation frequency; an angular frequency; an angular momentum; a torque. However, as the quantity of motion may also take a value of zero, so the motion state may also refer to a stationary state of the electric motor.

The term "accelerating" as used herein is a broad term and is to be given its ordinary and customary meaning to a person of ordinary skill in the art and is not to be limited to a special or customized meaning. The term specifically may refer, without limitation, to a change of the motion state induced by action of a force. Specifically, accelerating the electric motor may change its motion state from the first motion state to the second motion state. The term "accelerating" may refer to a positive acceleration, such as an increase of the at least one quantity of motion, or, alternatively, to a negative acceleration, such as a decrease of the at least one quantity of motion. The positive acceleration of the electric motor may involve increasing the kinetic energy of the electric motor, whereas the negative acceleration may involve decreasing the kinetic energy of the electric motor.

The terms "first" and "second" as used in the context of "first motion state" and "second motion state" are used for the purpose of nomenclature, only, without ranking or numbering these motion states and without giving any preferences. However, the term "first" and "second" may refer to a specific chronological order of the motion state of the electric motor. The first motion state of the electric motor may be a motion state of the electric motor preceding the second motion state of the electric motor. There may be further motion states besides the first and second motion states.

As further outlined above, the monitoring device comprises the at least one evaluation unit configured for evaluating the information on the amount of acceleration energy and for determining the at least one item of information on the wearing status of the electric motor. Therein, the evaluating of the information on the amount of acceleration energy may comprise one or more steps. Thus, the information on the amount of acceleration energy may directly be used for determining the item of information on the wearing status, or intermediate steps may be implemented. Thus, the information on the amount of acceleration energy may directly indicate the acceleration energy, as outlined above. Alternatively, however, the information on the amount of acceleration energy may comprise primary or more information, wherein the evaluating of the information may comprise deriving secondary information thereof, such as by calculating or determining the actual amount of acceleration energy from the raw information or primary information. As an example, the information on the amount of acceleration energy, as raw information, may comprise at least one measurement signal, wherein, prior to the evaluation or during the evaluation, the at least one measurement signal may be transformed into the actual amount of acceleration energy.

The term "evaluation unit" as used herein is a broad term and is to be given its ordinary and customary meaning to a person of ordinary skill in the art and is not to be limited to a special or customized meaning. The term specifically may refer, without limitation, to at least one electronic device configured for processing the information on the at least one amount of acceleration energy and/or any indication thereof. The information on the at least one amount of acceleration energy, as outlined above, may comprise at least one item of information such as at least one electronic item of information. As an example, the information may comprise at least one analogue and/or at least one digital item of electronic information, such as at least one analogue and/or at least one digital electronic signal. Specifically, the evaluation unit may be or may comprise one or more electronic components which may be combined in one single unit or, alternatively or additionally, may be separated from each other in a plurality of units. The electronic components may be configured for interacting with each other in order to perform the processing of the information on the at least one amount of acceleration energy and/or any indication thereof. Specifically, the processing may comprise evaluating the information on the amount of acceleration energy and determining the item of information on the wearing status. The evaluation unit may provide one or more hardware elements configured for performing one or more of the indicated processing operations and/or may provide one or more processors with software running thereon for performing one or more of the processing steps. For example, the evaluation unit may comprise at least one processor. The evaluation unit may comprise a software code stored thereon comprising a number of computer instructions for processing the information on the amount of acceleration energy.

The term "evaluating" as used herein is a broad term and is to be given its ordinary and customary meaning to a person of ordinary skill in the art and is not to be limited to a special or customized meaning. The term specifically may refer, without limitation, to a process of one or more of examining, processing, assessing, ranking or classifying the at least one amount of acceleration energy or any indication thereof. The result of the evaluation, as an example, may comprise at least one numeric value such as a numeric result and/or at least one Boolean value. Specifically, evaluating the information on the at least one amount of acceleration energy may comprise a comparison of the amount of acceleration energy with at least one reference value. A result of the comparison of the amount of acceleration energy with the reference value may be used for further processing. Specifically, evaluating of the amount of acceleration energy may provide basis for a determination of the item of information on the wearing status of the electric motor. Additionally or alternatively, the term "evaluating" may refer to an analysis of the information on the amount of acceleration energy in order to quantitatively determine the amount of acceleration energy.

The term "information", also referred to as "at least one item of information" as used herein is a broad term and is to be given its ordinary and customary meaning to a person of ordinary skill in the art and is not to be limited to a special or customized meaning. The term specifically may refer, without limitation, to one or more signals such as electronic signals and/or one or more numerical values indicating at least one property, quantity, quality, feature or characteristic of at least one entity to be described by the item of information.

Thus, in the context of the amount of acceleration energy, the information on the acceleration energy specifically may comprise at least one signal and/or at least one numerical value from which the amount of acceleration energy may derived and/or which directly or indirectly allows for deriving the at least one amount of acceleration energy. The at least one item of information may be or may comprise an absolute information and/or a relative information. As an example, a relative information on the amount of acceleration energy may be or may comprise one or more of a difference between the amount of acceleration energy and at least one reference value and/or a quotient of the amount of acceleration energy and at least one reference value.

The term "wearing status of the electric motor" as used herein is a broad term and is to be given its ordinary and customary meaning to a person of ordinary skill in the art and is not to be limited to a special or customized meaning. The term specifically may refer, without limitation, to a condition of the electric motor regarding its functioning, specifically a proper functioning. Specifically, the wearing status of the electric motor may describe a wearing and/or tearing of one or more of the electric motor's components, such as wearing and/or tearing of the commutator and/or the brushes. Further, the wearing status of the electric motor may also indicate a defective functioning of the electric motor, for example due to breaking of the conductors, short circuit of the conductors and/or other harmful operating conditions. Consequently, in the context of the wearing status, the at least one item of information on the wearing status may comprise at least one item of information as defined above directly or indirectly describing the wearing status. The item of information may, as outlined above, comprise at least one numerical value and/or at least one Boolean value. The numerical value, as an example, may describe a degree of the wearing status, such as on a given Scale, e.g. a scale of percent. A Boolean value, as an example, may simply distinguish between "in order" and "not in order", "not to be replaced" and "to be replaced soon", "functioning" and "non functioning" or the like.

The term "determining" as used in the context of the evaluation unit is a broad term and is to be given its ordinary and customary meaning to a person of ordinary skill in the art and is not to be limited to a special or customized meaning. The term specifically may refer, without limitation, to a process in which the information on the amount of acceleration energy is used for generating the at least one item of information on the wearing status of the electric motor. As an example, at least one algorithm may be applied to the information on the amount of acceleration energy, the result comprising the item of information on the wearing status. Therein, various types of algorithms may be used, such as algorithms comprising a simple comparison of the amount of acceleration energy with one or more reference values, algorithms transforming the amount of acceleration energy by using analytical, empirical or semi-empirical transformations, algorithms using lookup tables, or even algorithms based on artificial intelligence, such as algorithms comprising trained models or the like. Specifically, the determining of the item of information on the wearing status may comprise using the difference between the amount of acceleration energy and at least one reference value and/or may comprise using the quotient of the amount of acceleration energy and the reference value. Other options, however, are feasible.

The at least one item of information on the wearing status, as outlined above, may be or may comprise at least one electronic item of information, such as an analogue and/or a digital value. Other options, however, are feasible. The information on the wearing status, specifically, may be one or more of stored in a data storage, transmitted to another device and/or displayed or brought to the attention of a user of the monitoring device, such as by displaying or other means.

As outlined above, the acceleration energy may specifically be selected from the group consisting of: a positive acceleration energy required for positively accelerating the electric motor from a first motion state of lower kinetic energy to a second motion state of higher kinetic energy; a negative acceleration energy required for negatively accelerating the electric motor from a first motion state of higher kinetic energy to a second motion state of lower kinetic energy. Specifically, the motion state of lower kinetic energy may be a motion state having a quantity of motion, such as the speed of rotation, the rotation frequency, the angular frequency, the angular momentum, being lower than the corresponding quantity of motion of the motion state of higher kinetic energy. Similarly, the motion state of higher kinetic energy may be a motion state having a quantity of motion exceeding the corresponding quantity of motion of the motion state of lower kinetic energy. The acceleration energy comprises an acceleration energy which is at least one of dissipated, recuperated or released when decelerating the electric motor from a rotating motion state to a stationary state. Alternatively or additionally, the acceleration energy may comprise an acceleration energy required for accelerating the electric motor from the stationary state to the rotating state.

The idea of using an acceleration energy which is at least one of dissipated, recuperated or released when decelerating the electric motor from a rotating motion state to a stationary state provides several advantages. Thus, specifically, no well-defined testing conditions have to be established for monitoring the electric motor. Thus, decelerations of electric motors often occur in daily use of laboratory systems, typically from a standardized rotational speed to zero, such as when stopping a motion of a manipulation system or conveyor driven by the electric motor. Thus, for example, the monitoring device may be configured for waiting for an operation condition in which the electric motor is decelerated from a predefined rotating motion state to zero, i.e. the stationary state, and may, without the necessity of providing testing conditions, determine the acceleration energy which is at least one of dissipated, recuperated or released during that deceleration. Thus, the monitoring device specifically may be configured for determining if the condition for measurement is met, such as by determining if a signal for deceleration from a rotating motion state, such as from a specific rotating motion state, to the stationary state is provided, and may then, once the condition is found to be met, start the determining of the acceleration energy which is at least one of dissipated, recuperated or released during that deceleration. The monitoring device, thus, may make use of operating conditions during daily use of the laboratory system, without the need for establishing dedicated measurement or monitoring conditions.

Further, the receiving unit may comprise at least one of a measurement resistor, a measurement capacitor and an energy buffer. The measurement resistor and/or the measurement capacitor may be configured for being used for determining and/or measuring the at least one amount of acceleration energy required for accelerating the electric motor, thereby determining the information on the acceleration energy. The energy buffer may be configured for storing the at least one amount of acceleration energy, such as the acceleration energy being dissipated, recuperated or released when decelerating the electric motor. The receiving unit may further comprise at least one measurement device configured for monitoring at least one of a voltage, a current or a power at the measurement resistor, the measurement capacitor or the energy buffer, respectively. The voltage, the current and/or the power monitored by the measurement device may be indicative of the amount of acceleration energy and, thus, may directly or indirectly be used as items of information on the amount of acceleration energy and/or for determining the information on the amount of acceleration energy.

The measurement device may be configured for generating at least one measurement signal indicative of the voltage, the current or the power, respectively, as a function of time. The measurement device may be configured for providing the measurement signal to the evaluation unit. The monitoring device may further comprise at least one filtering device, specifically for filtering the at least one measurement signal, specifically at least one low pass filter. The filtering device may be arranged in between the measurement device and the evaluation unit for filtering the measurement signal provided from the measurement device to the evaluation unit. The measurement signal may directly or indirectly be used as at least one item of information on the amount of acceleration energy. For example, the information on the amount of acceleration energy may comprise the measurement signal, specifically one or more of the voltage, the current or the power, integrated over time. The integrating of the measurement signal may be performed by computation or, alternatively, electronically by using appropriate electronic circuits, such as electronic integrators or capacitors. The evaluation unit may be configured for evaluating the measurement signal, thereby determining the item of information on the wearing status of the electric motor.

The evaluation unit, as outlined above, may comprise at least one processor for determining the at least one item of information on the wearing status. The term "processor" as used herein is a broad term and is to be given its ordinary and customary meaning to a person of ordinary skill in the art and is not to be limited to a special or customized meaning. The term specifically may refer, without limitation, to an arbitrary logic circuitry configured for performing basic operations of a computer or system, and/or, generally, to a device which is configured for performing calculations or logic operations. In particular, the processor may be configured for processing basic instructions that drive the computer or system. As an example, the processor may comprise at least one arithmetic logic unit (ALU), at least one floating-point unit (FPU), such as a math co-processor or a numeric co-processor, a plurality of registers, specifically registers configured for supplying operands to the ALU and storing results of operations, and a memory, such as an L1 and L2 cache memory. In particular, the processor may be a multi-core processor. Specifically, the processor may be or may comprise a central processing unit (CPU). Additionally or alternatively, the processor may be or may comprise a microprocessor, thus specifically the processor's elements may be contained in one single integrated circuitry (IC) chip. Additionally or alternatively, the processor may be or may comprise one or more application-specific integrated circuits (ASICs) and/or one or more field-programmable gate arrays (FPGAs) and/or one or more tensor processing unit (TPU) and/or one or more chip, such as a dedicated machine learning optimized chip, or the like.

The evaluation unit may be configured, such as by hardware configuration and/or by software programming of the hardware, for example by software programming of the processor, for determining the at least one item of information on the wearing status. The evaluation unit may further be configured for determining at least one recommended action on the basis of the item of information on the wearing status. As an example, the recommended action may be an action to be performed by a user of the electric motor and/or the laboratory system, such as operating personal and/or maintenance personal. As an example, the recommended action may be determined on the basis of an algorithm, the algorithm making use of the at least one item of information on the wearing status of the electric motor. As a simple example, a lookup table may be used, e.g. for transforming the information on the wearing status into a recommended action. The evaluation unit further may be configured for outputting the recommended action. The at least one recommended action may comprise at least one of: continuing operation with the electric motor; discontinuing operation with the electric motor; performing at least one maintenance step; exchanging the electric motor; exchanging or maintaining at least one driven part, specifically at least one gear or at least one other driven part.

The evaluation unit may further be configured, on the basis of the item of information on the wearing status, for determining if at least one warning state is given. The warning state may indicate, as an example, a substantial and/or dangerous wearing status of the electric motor requiring immediate action and/or action within the near future. The evaluation unit may be configured, if the warning state is given, for outputting a warning. Specifically, the evaluation unit may be configured for outputting the warning via at least one user interface. The user interface may be configured for providing the warning to a user of the monitoring device, specifically to a user of the laboratory system, by one or more of visual means, such via at least one display, haptic means and/or audible means.

In a further aspect of the present invention, a laboratory system for performing at least one laboratory task is disclosed. The laboratory system comprises at least one electric motor and further at least one monitoring device according to the present invention, such as according to any one of the embodiments disclosed above and/or according to any one of the embodiments disclosed in further detail below.

The term "laboratory system" as used herein is a broad term and is to be given its ordinary and customary meaning to a person of ordinary skill in the art and is not to be limited to a special or customized meaning. The term "system", as used herein, may generally refer to an arbitrary set of interacting components being configured for interacting in order to perform at least one common task. Specifically, the components of the laboratory system may interact with each other in order to perform at least one laboratory task. The at least two components may be handled independently or may be coupled or connectable. The laboratory system specifically may be or may comprise an automated laboratory system configured for automatically or semi-automatically processing a plurality of samples, specifically a large number of samples. As an example, the laboratory system may be or may comprise an automated laboratory analyzer. The laboratory system specifically may be used in the field of medical laboratories, such as in clinical laboratories or in forensic laboratories, and/or in the field of chemical laboratories, such as in analytic laboratories.

For exemplary embodiments of laboratory systems which may also be used in the context of the present invention, with the modifications as discussed herein, reference may be made e.g. to WO 2015/011274 A2, EP 3056320 A1 or EP 3412603 A1. Other laboratory systems, however, may also be used.

The term "laboratory task" as used herein is a broad term and is to be given its ordinary and customary meaning to a person of ordinary skill in the art and is not to be limited to a special or customized meaning. The term specifically may refer, without limitation, to a task performed in the field of medical and/or chemical laboratories. For example, the laboratory task may comprise one or more of moving samples, storing samples, analyzing samples, preparing samples for analysis, adding reagents to samples, adding solvents to samples, mixing samples, distributing samples, heating samples, cooling samples, and splitting samples. A sample may comprise at least one aliquot of a substance being handled in medical laboratories, such as biological samples and/or bodily fluids, and/or in chemical laboratories, such as chemical substances, compounds and/or reagents. Further, laboratory tasks may be performed in different locations of the laboratory system. Thus, the laboratory task may also comprise transporting, moving, transferring and/or conveying one or more samples from one location in the laboratory system to another location in the laboratory system. The laboratory system may specifically comprise using the electric motor for transporting, moving, transferring and/or conveying of the samples.

Consequently, besides the at least one electric motor and the at least one monitoring device, the laboratory system may further comprise one or more further components. As an example, the laboratory system may comprise one or more devices configured for at least one of: moving samples, storing samples, analyzing samples, preparing samples for analysis, adding reagents to samples, adding solvents to samples, mixing samples, distributing samples, heating samples, cooling samples, splitting samples, storing samples, transporting samples, moving samples, transferring samples, conveying samples. Devices for such purposes are generally known to the skilled person. The at least one electric motor may form part of one or more of these devices, such as of one or more devices for transporting or moving samples, e.g. one or more sample transfer stages and/or one or more rotating stages. Other examples are feasible.

For further definitions and options of the laboratory system, reference may be made to the description of the monitoring device in one or more of the embodiments given above and/or according to any one of the embodiments described in further detail below.

The laboratory system may further comprise at least one electronic switching element, specifically at least one H-bridge. The electronic switching element may be configured for at least one of reversing a polarity of a voltage applied to the electric motor and negatively accelerating the electric motor. The term "H-bridge" as used herein is a broad term and is to be given its ordinary and customary meaning to a person of ordinary skill in the art and is not to be limited to a special or customized meaning. The term specifically may refer, without limitation, to an electronic circuit configured for reversing a polarity of a voltage applied to a load. Specifically, the H-bridge may be configured for reversing a polarity of the voltage applied to the electric motor. The H-bridge may comprise one or more electronic switches, transistors or any other electronic components which may be configured, in one state, for allowing transmittance of electronic signals, such as a voltage or a current, and, in another state, for blocking electronic signals. Specifically, the H-bridge may comprise at least two electrical branches connected in a parallel fashion, wherein each branch contains at least two switches in a serial setup with a node in between the switches, wherein the electric motor is located in a connection bridging the nodes of the branches. The polarity of a voltage applied to the electric motor, when a voltage is applied to the branches, thus, may depend on the combination of switching states of the at least four switches. The one or more electronic components of the H-bridge may be configured for being actively and/or passively controlled such that their state may be changeable. The H-bridge may have at least two states of configuration. For example, in a first state of configuration, the H-bridge may apply the voltage to the electric motor such that the electric motor is positively accelerated. The polarity of the voltage applied to the electric motor may be reversed by changing the state of the components comprised by the H-bridge. In a second state of configuration, the H-bridge may apply the voltage to the electric motor such that the electric motor is negatively accelerated.

Further, the laboratory system may comprise at least one controller, specifically at least one microcontroller, for controlling the functionality of the electric motor, specifically via the at least one electronic switching element. The term "controller" as used herein is a broad term and is to be given its ordinary and customary meaning to a person of ordinary skill in the art and is not to be limited to a special or customized meaning. The term specifically may refer, without limitation, to an electronic device configured, specifically by hardware and/or by software programming, for controlling a functionality of the electric motor. The controller may specifically comprise one or more processors as described above. The controller may be configured for interacting with other components of the laboratory system, such as by receiving one or more signals from other components, for example from one or more of the receiving unit or the evaluation unit of the monitoring device, and/or by providing one or more signals to other components of the laboratory system, such as to the electronic switching element, specifically to the H-bridge. The controller may be configured for controlling the electronic switching element, specifically the H-bridge, thereby controlling the voltage applied to the electric motor. The evaluation unit of the monitoring device may be at least partially comprised by the controller.

The laboratory system may further comprise at least one energy source for providing electrical energy to the electric motor. The energy source, as an example, may be or may comprise a power supply connectable to an external power source, and/or may be or may comprise an internal energy source, such as a battery and/or an accumulator.

In a further aspect of the present invention, a method of monitoring an electric motor, specifically of a laboratory system is disclosed. The method comprises the following steps which specifically may be performed in the given order. It shall be noted, however, that a different order is also possible. Further, it is also possible to perform one or more of the method steps once or repeatedly. Further, it is possible to perform two or more of the method steps simultaneously or in a timely overlapping fashion. The method may comprise further method steps which are not listed.

The method comprises:
i) receiving information on at least one amount of acceleration energy required for accelerating the electric motor from at least one first motion state to at least one second motion state, specifically in at least one receiving unit of a monitoring device;
ii) evaluating the information on the amount of acceleration energy and determining at least one item of information on a wearing status of the electric motor, specifically in at least one evaluation unit of a monitoring device.

For definitions and options of the method of monitoring the electric motor, reference may be made to the description of the monitoring device in one or more of the embodiments given above and/or according to any one of the embodiments described in further detail below.

The method may be at least partially computer-implemented, wherein, specifically, step ii) may be at least partially computer-implemented. The term "at least partially computer-implemented" as used herein specifically may refer, without limitation, to embodiments wherein the method is fully computer-implemented or computer-controlled or to embodiments wherein a part the method steps, specifically all of the operations performed in step ii) or a part of the operations performed in step ii), are computer-implemented. For example, one or both of evaluating the information on the amount of acceleration energy and determining the item of information on the wearing status of the electric motor may be computer-implemented.

The method may specifically comprise using the monitoring device according to the present invention, such as according to any one of the embodiments disclosed above and/or according to any one of the embodiments disclosed in further detail below.

Further, step ii) of the method may comprise comparing the amount of acceleration energy with at least one reference value. Specifically, step ii) may comprise comparing at least one of a quotient of the amount of acceleration energy and the reference value or a difference between the amount of acceleration energy and the reference value with at least one threshold value. The threshold value may be a value amounting to 20 % to 90 % of an initial amount of acceleration energy required for accelerating the electric motor from the at least one first motion state to at least one initial motion state when the electric motor was new, specifically a value amounting to 50 % to 80 % of the initial amount of acceleration energy, more specifically a value amounting to 70 % of the initial amount of acceleration energy. Thus, as an example, firstly, the initial amount of acceleration energy may be determined or may be stored. Further, at a later point in time, a current value of the acceleration energy may be determined. A quotient of the current and the initial values may be formed, thereby deriving a percentage, and, as an example, the percentage may be compared with one or more percentage threshold values, in order to determine the at least one item of information on the wearing status. Thus, as an example, in case the quotient reaches a value of 70 %, the information on the wearing status may be set to a value indicating that the electric motor requires maintenance or needs to be exchanged. Other examples are feasible.

The initial amount of acceleration energy may be an amount of acceleration energy required for accelerating the electric motor during a first, initial motion. For example, when the electric motor is newly installed, the electric motor may be accelerated from the first motion state to the initial motion state for the first time. Alternatively, the initial amount of acceleration energy may be an amount of acceleration energy required for accelerating the electric motor after a predetermined run-in period. Other examples of defining an initial point in time for determining the initial amount of acceleration energy are feasible. Thus, generally, the initial motion state may refer to the second motion state of the first, initial motion of the electric motor. The amount of acceleration energy required for accelerating the electric motor for the first time may be determined and may be used as the initial amount of acceleration energy.

The reference value may be a reference value selected from the group consisting of: a predetermined reference value; a reference value determined by using the initial amount of acceleration energy required for accelerating the electric motor from the at least one first motion state to the at least one initial motion state when the electric motor was new. Specifically, the predetermined reference value may be or may comprise a fixed, preset reference value, for example depending on a type and/or a characteristic of the electric motor. The reference value determined by using the initial amount of acceleration energy may comprise a reference value being individually determined for the electric motor.

Further, as outlined above, method step ii) may comprise using an algorithm for evaluating the information on the amount of acceleration energy and thereby determining the at least one item of information on the wearing status. As outlined above, various types of algorithms may be used, including conventional algorithms, the use of lookup tables or the use of artificial intelligence. Specifically, method step ii) may comprise using at least one trained model, such as an artificial neural network in a trained state. The term "trained model" as used herein is a broad term and is to be given its ordinary and customary meaning to a person of ordinary skill in the art and is not to be limited to a special or customized meaning. The term specifically may refer, without limitation, to a model for predicting maintenance of the electric motor which was trained on at least one training dataset, also denoted training data. In particular, the trained model may be trained on the training dataset that is classified by experts. For example, by performing the method of monitoring the electric motor, training data may be obtained by recording one or more of the amount of acceleration energy, the item of information on the wearing status of the electric motor, the threshold value and the recommended action. Thus, for a plurality of electric motors, the item of information on the amount of acceleration energy may be determined and, further, the wearing status of the electric motor may be determined, e.g. by visual inspection and/or other means. Thereof, a set of training data may be generated which may be used for training a model such as an artificial neural network. Further, the training data may comprise a time stamp identifying a point in time at which the training data were recorded. The trained model may be configured for predicting, based on the training data, specifically based on the time stamp, a future point in time when the quotient and/or the difference of the amount of acceleration energy and the reference value is expected to be lower than the threshold value. Thus, the trained model may be configured for predicting a future point in time when the item of information on the wearing status of the electric motor is expected to indicate a defective electric motor. Further, it may be possible to classify these predictions by experts, for example as correct or incorrect. The trained model may be configured for adapting the prediction according to the classification performed by experts.

In a further aspect of the present invention, a method of operating a laboratory system for performing at least one laboratory task is disclosed. The method comprises the following steps which specifically may be performed in the given order. It shall be noted, however, that a different order is also possible. Further, it is also possible to perform one or more of the method steps once or repeatedly. Further, it is possible to perform two or more of the method steps simultaneously or in a timely overlapping fashion. The method may comprise further method steps which are not listed.

The method comprises:
I. manipulating at least one object by using an electric motor;
II. monitoring the electric motor by using the method of monitoring the electric motor according to the present invention, such as according to any one of the embodiments disclosed above and/or according to any one of the embodiments disclosed in further detail below.

Step I. specifically may form part of a routine operation of the laboratory system. Additionally or alternatively, step I. may also be performed during a specific maintenance or test routine, such as a dedicated routine for testing the electric motor. Thus, the monitoring of the electric motor in step II. may be performed during routine operation of the electric motor and/or may be performed during a separate routine, such as a maintenance or test routine, wherein, in the first case, the electric motor may be used for the laboratory task, whereas, in the second case, the electric motor may be operated for test purposes. Other options are feasible.

The at least one object manipulated by the electric motor specifically may be selected from the group consisting of at least one sample and at least one other component of the laboratory system. Thus, as an example, the at least one object manipulated by the electric motor may be or may comprise at least one sample, such as at least one sample vessel containing the sample, e.g. at least one sample tube. Additionally or alternatively, the at least one object manipulated by the electric motor may also comprise another component of the laboratory system, such as at least one linear stage and/or at least one rotating stage. Other objects are feasible. Specifically, the entire method or at least step II. may be performed at least once within a predetermined period of time. For example, the monitoring may be performed continuously, and intermittently or at least once within a predetermined or variable time span, such as within one day, one week, one month or any other period of time.

In a further aspect, a computer program is proposed, comprising instructions which, when the program is executed by the evaluation unit of the monitoring device according to the present invention, such as according to any one of the embodiments disclosed above and/or according to any one of the embodiments disclosed in further detail below, cause the evaluation unit to perform at least step ii) of the method of monitoring an electric motor according to the present invention, such as according to any one of the embodiments disclosed above and/or according to any one of the embodiments disclosed in further detail below.

Similarly, a computer-readable storage medium is proposed, comprising instructions which, when the program is executed by the evaluation unit of the monitoring device according to the present invention, such as according to any one of the embodiments disclosed above and/or according to any one of the embodiments disclosed in further detail below, cause the evaluation unit to perform at least step ii) of the method of monitoring an electric motor according to the present invention, such as according to any one of the embodiments disclosed above and/or according to any one of the embodiments disclosed in further detail below.

As used herein, the term "computer-readable storage medium" specifically may refer to non-transitory data storage means, such as a hardware storage medium having stored thereon computer-executable instructions. The computer-readable data carrier or storage medium specifically may be or may comprise a storage medium such as a random-access memory (RAM) and/or a read-only memory (ROM).

In a further aspect, a computer program is proposed, comprising instructions which, when the program is executed by the laboratory system according to the present invention, such as according to any one of the embodiments disclosed above and/or according to any one of the embodiments disclosed in further detail below, cause the laboratory system to perform at least step II) of the method of operating a laboratory system according to the present invention, such as according to any one of the embodiments disclosed above and/or according to any one of the embodiments disclosed in further detail below.

Similarly, a computer-readable storage medium is proposed, comprising instructions which, when the program is executed by the laboratory system according to the present invention, such as according to any one of the embodiments disclosed above and/or according to any one of the embodiments disclosed in further detail below, cause the laboratory system to perform at least step II) of the method of operating a laboratory system according to the present invention, such as according to any one of the embodiments disclosed above and/or according to any one of the embodiments disclosed in further detail below.

The devices, system and methods according to the present invention provide a large number of advantages over known methods and devices of similar kind. Specifically, the devices and methods according to the present invention may provide means for automatically monitoring the electric motor, specifically the operation conditions of the electric motor. Thus, it may be possible to detect malfunctioning of the electric motor due to wearing of the electric motor's components, such as the commutator and/or the brushes, due to breaking of windings, winding short circuit and/or other harmful operating conditions. In addition, the devices and methods may allow an automated monitoring of the electric motor, specifically without the need for operators or users to check the wearing status of the electric motor.

Further, the devices and methods according to the present invention may allow for predictive maintenance of the electric motor. For example, it may be possible to evaluate a future point in time when the electric motor will have to be changed. Additionally, the devices and methods may provide means for an indirect monitoring of the electric motor since the monitoring device may be arranged separate from the electric motor in the laboratory system. Thus, using the devices and methods according to the present invention may overcome the need for disassembling the electric motor when checking the wearing status of the electric motor. Further, the monitoring of the electric motor may be performed during operation of the laboratory system. Additionally or alternatively, the monitoring of the electric motor may be performed during a maintenance procedure, such as by maintenance personal checking the wearing status during a maintenance routine, such as on a regular or irregular basis. Further additionally or alternatively, the monitoring of the electric motor may be performed during a troubleshooting process, such as in case a malfunctioning of the laboratory system occurs.

The devices and methods according to the present invention may allow monitoring the electric motor, specifically of the laboratory system, whereby a motion system, such as a stage and/or a propulsion system of the laboratory system, making use of the electric motor may be operated in an essentially fail-safe manner. Generally, known methods and devices dissipate the amount of acceleration energy required for decelerating the electric motor. Contrarily, the devices and methods described herein may be configured for making use of this acceleration energy for determining information on the amount of acceleration energy and for evaluating the information on the amount of acceleration energy. When the electric motor is newly installed in the laboratory system, the electric motor may be accelerated and decelerated in a controlled manner. The amount of acceleration energy of this initial motion may be determined and stored as the reference value. The measurement signal may comprise a power of the electric motor's motion measured in Watts. However, the amount of acceleration energy may be determined from this measurement by monitoring the measurement signal as a function of time. After determining the initial amount of acceleration energy as the reference value, receiving the amount of acceleration energy may be performed periodically, such as at least once within one day, one week, two weeks and/or one month. Evaluating the information on the amount of acceleration energy and determining the item of information on the wearing status of the electric motor may be performed during operation of the electric motor, specifically during operation of the laboratory system. A central computing unit of the laboratory system, such as the controller, may decide on the timing of performing the method of monitoring the electric motor. The evaluation unit of the monitoring device may able to decide individually for each electric motor when to be changed due to increased wear or low performance.

The electric motor may generate a torque acting on a mechanics to be moved. The electric motor may generate equal torque when being operated with the same operating parameters. The mechanics moved by the electric motor may have a particular mass. By applying the generated torque to the mechanics, the electric motor may accelerate the mechanics within a predetermined time interval to a given motion state. When the electric motor is in proper condition, the motion state may be the same upon repeated acceleration. By decelerating the electric motor, the amount of acceleration energy may be dissipated and may be determined by the monitoring device. The amount of acceleration energy may be equal to the reference value if the electric motor is in proper condition. The initial amount of acceleration energy may be at its maximum for a new electric motor and, thus, may be used as the reference value. The reference value may be redetermined when exchanging the electric motor of the laboratory system. The method of monitoring the electric motor may be performed after initialization of the motion axis. The method may be performed repeatedly based on a predetermined cycle. Specifically, the method may be repeated at least once within one day, one week, one month or the like. The amount of acceleration energy determined by using the method of monitoring the electric motor may be stored, for example on the evaluation unit of the monitoring device, and may be compared to the reference value. In case the electric motor is in proper condition, the amount of acceleration energy may not differ from the reference value. However, the electric motor may not be able to provide its initial torque because of aging and/or wearing effects of the electric motor's components. Thus, the motor may not be able to provide its initial amount of acceleration energy anymore. These effects may reduce the amount of acceleration energy provided by the electric motor. The monitoring device may be configured for determining if the amount of acceleration energy is lower than the reference value, for example lower than 70 % of the initial amount of acceleration energy, and, if this is the case, may output the recommended action, for example indicating that the electric motor has to be changed or maintained.

### Short description of the Figures

Further optional features and embodiments will be disclosed in more detail in the subsequent description of embodiments, preferably in conjunction with the dependent claims. The embodiments are schematically depicted in the Figures. Therein, identical reference numbers in these Figures refer to identical or functionally comparable elements.

In the Figures:
- Figure 1: shows embodiments of a laboratory system and a monitoring device for monitoring an electric motor in a schematic view;
- Figure 2: shows a diagram of a measurement signal as a function of time;
- Figure 3: shows a flow chart of an embodiment of a method of monitoring an electric motor;
- Figure 4: shows a flow chart of an embodiment of a method of operating a laboratory system;
- Figure 5: shows a diagram of operations modes of an electric motor; and
- Figure 6: shows an embodiment of a receiving unit.

### Detailed description of the embodiments

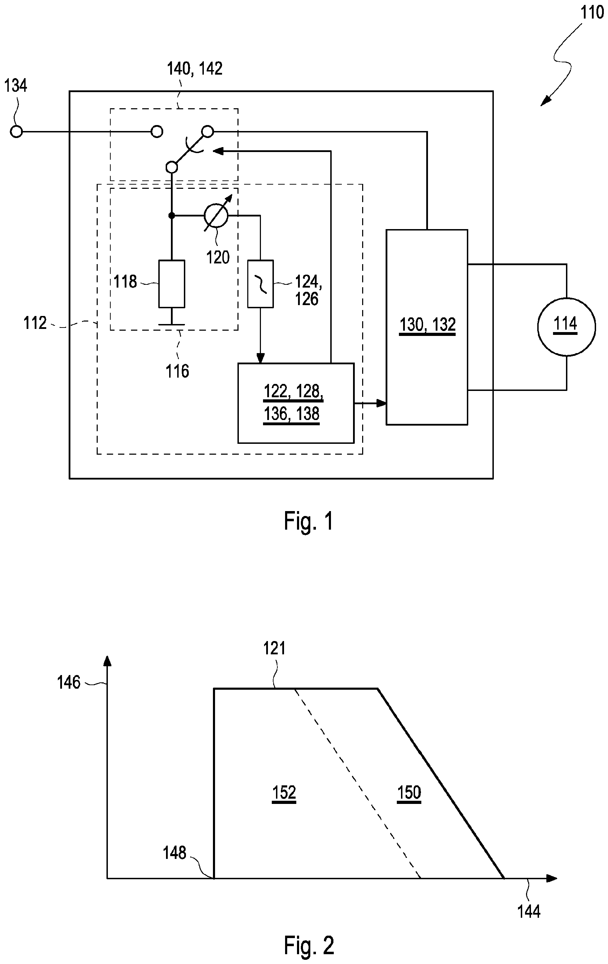

Figure 1 shows exemplary embodiments of a laboratory system 110 for performing at least one laboratory task and of a monitoring device 112 for monitoring an electric motor 114 in a schematic view. The laboratory system 110 comprises the at least one electric motor 114 and the at least one monitoring device 112. The monitoring device 112 may specifically be configured for monitoring the electric motor 114 of the laboratory system 110. However, other fields of application of the monitoring device 112 are feasible. The laboratory system 110 may comprise one or more other components configured for performing at least one laboratory task which are not depicted in Figure 1. For exemplary embodiments, reference may be made to the description and the prior art given above.

The monitoring device 112 comprises at least one receiving unit 116 configured for receiving information on at least one amount of acceleration energy required for accelerating the electric motor 114 from at least one first motion state to at least one second motion state. The acceleration energy comprises an acceleration energy which is at least one of dissipated, recuperated or released when decelerating the electric motor 114 from a rotating motion state to a stationary state.

In the exemplary embodiment of Figure 1, the receiving unit 116 may comprise at least one measurement resistor 118. The measurement resistor 118 may be configured for being used for determining and/or measuring the at least one amount of acceleration energy required for accelerating the electric motor 114. However, other devices for determining the amount of acceleration energy, such as a measurement capacitor and/or an energy buffer, are also feasible. The receiving unit 116 may further comprise at least one measurement device 120 configured for monitoring at least one of a voltage, a current or a power at the measurement resistor 118. The voltage, the current and/or the power monitored by the measurement device 120 may be indicative of the amount of acceleration energy.

The measurement device 120 may be configured for generating at least one measurement signal 121 indicative of the voltage, the current or the power, respectively, as a function of time. The at least one measurement signal 120 may directly or indirectly be used as at least one item of information on the amount of acceleration energy and/or for deriving the information on the amount of acceleration energy. An exemplary embodiment of the measurement signal 121 is shown in Figure 2. Thus, reference may be made to the description of Figure 2. The measurement device 120 may be configured for providing the measurement signal 121 to an evaluation unit 122. The monitoring device 112 may further comprise at least one filtering device 124, specifically for filtering the at least one measurement signal 121. Thus, as indicated above, the item of information on the amount of acceleration energy may also be derived from the measurement signal, e.g. by filtering, so the information on the amount of acceleration energy may be contained in or derivable from the filtered measurement signal. As shown in Figure 1, the filtering device 124 may be or may comprise at least one low pass filter 126. The filtering device 124 may be arranged in between the measurement device 120 and the evaluation unit 122 for filtering the measurement signal 121 provided from the measurement device 120 to the evaluation unit 122.

The monitoring device 112 further comprises the at least one evaluation unit 122 configured for evaluating the item of information on the amount of acceleration energy and for determining at least one item of information on a wearing status of the electric motor 114. The evaluation unit 122 may be configured for further processing the item on the amount of exploration energy, such as by deriving further information, e.g. an absolute value and/or a relative value of the amount of acceleration energy from the measurement signal 121.

The evaluation unit 122 may comprise at least one processor 128 for determining the at least one item of information on the wearing status, by using the information on the amount of acceleration energy, e.g. the measurement signal 121 and/or at least one item of information derived thereof. The evaluation unit 122 is configured, for example by software programming of the processor 128, for determining the at least one item of information on the wearing status of the electric motor 114. The evaluation 122 unit may further be configured for determining at least one recommended action on the basis of the item of information on the wearing status. The evaluation unit 122 may further be configured for outputting the recommended action. The at least one recommended action may comprise at least one of: continuing operation with the electric motor 114; discontinuing operation with the electric motor 114; performing at least one maintenance step; exchanging the electric motor 114; exchanging or maintaining at least one driven part, specifically at least one gear or at least one other driven part.

Further, the evaluation unit 122 may be configured, on the basis of the item of information on the wearing status, for determining if at least one warning state is given. The warning state may indicate a substantial and/or dangerous wearing status of the electric motor 114. The evaluation unit 122 may be configured, if the warning state is given, for outputting a warning. Specifically, the evaluation unit 122 may be configured for outputting the warning via at least one user interface, which is not shown in Figure 1. The user interface may be configured for providing the warning to a user of the monitoring device 112, specifically to a user of the laboratory system 110, by one or more of visual means, such via at least one display, haptic means and/or audible means.

In the exemplary embodiment of Figure 1, the laboratory system 110 may further comprise at least one electronic switching element 130. For example, the electronic switching element 130 may be or may comprise at least one H-bridge 132. For example, the H-bridge 132 may comprise an electronic circuit comprising at least four switches. The electronic circuit of the H-bridge 132 may comprise at least two electrical branches connected in a parallel fashion, wherein at least two switches may be connected in series in each of the electric branches. Further, the electric circuit of the H-bridge 132 may comprise a node in between the at least two switches, wherein the electric motor 114 may be located in a connection bridging the nodes of the branches. A polarity of a voltage applied to the electric motor 114, when a voltage is applied to the branches, thus, may depend on the combination of switching states of the at least four switches. The H-bridge 132 may be configured, in one state of configuration of the electronic switches, for switching a polarity of a voltage applied to the electric motor 114. However, in another state of configuration of the electronic switches, the H-bridge 132 may configured for negatively accelerating the electric motor 114.

The laboratory system 110 may further comprise at least one energy source 134 for providing electrical energy to the electric motor 114. As can be seen in Figure 1, the electronic switching element 130 may be inserted in between the energy source 134 and the electric motor 114. The electronic switching element 130 may be configured for at least one of reversing a polarity of a voltage applied to the electric motor 114 and negatively accelerating the electric motor 114.

Further, the laboratory system 110 may comprise at least one controller 136. For example, the controller 136 may be or may comprise at least one microcontroller 138. The controller 136 may be configured for controlling the functionality of the electric motor 114, specifically via the at least one electronic switching element 130. Generally, the controller 136 may be configured for adjusting and/or determining at least one parameter of operation of the electric motor 114, e.g. by providing one or more of driving signals, driving commands or electrical control signals to the electric motor 114. In the exemplary embodiment of Figure 1, the evaluation unit 122 of the monitoring device 112 may be at least partially comprised by the controller 136 of the laboratory system 110. Other options, in which the evaluation unit 122 and the controller 136 are fully or partially separated, are also feasible.

The laboratory system 110 may further comprise at least one electronic switch 140. For example, the electronic switch 140 may comprise at least one changeover switch 142. The electronic switch 140 may be controlled by the at least one controller 136 of the laboratory system 110. The electronic switch 140 may comprise at least two positions, wherein, in a first position, the electronic switch 140 may connect the electric motor 114 to the energy source 134 of the laboratory system 110, wherein, in a second position, the electronic switch 140 may connect the electric motor 114 to the monitoring device 112, specifically to the receiving unit 116, more specifically to the measurement resistor 118.

In Figure 2, a diagram of the measurement signal 121 as a function of time 144 is shown. In the diagram, the time 144 is plotted on the abscissa of the diagram and a power 146 determined by the measurement device 120 is plotted on the ordinate of the diagram. As indicated by reference number 148 in Figure 2, the measurement signal 121 may start at a point in time when the electric motor 114 is accelerated, either positively or negatively. The measurement device 120 may be configured for monitoring the power 146 generated by the electric motor 114 when being accelerated. The evaluation unit 122 may be configured for evaluating the measurement signal 121. Specifically, the area enclosed by the measurement signal 121 in the diagram may correspond to the amount of acceleration energy. In case the electric motor 114 is new, the amount of acceleration energy 150 may be larger compared to a situation in which the electric motor 114 is malfunctioning. In this case, the amount of acceleration energy 152 may be smaller than the amount of acceleration energy 150 for the proper functioning electric motor 114.

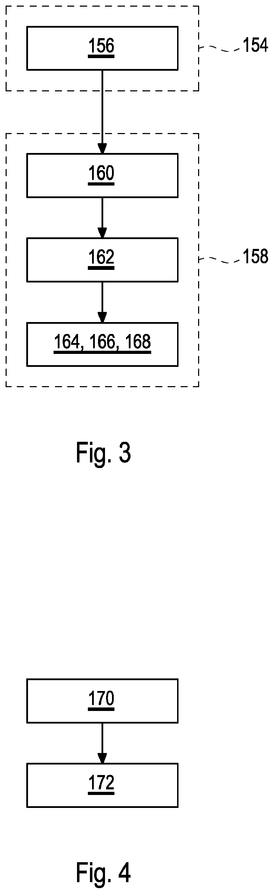

Figure 3 shows a flow chart of an exemplary embodiment of a method of monitoring the electric motor 114. The method comprises the following steps, which may specifically be performed in the given order. Still, a different order may also be possible. It may be possible to perform two or more of the method steps fully or partially simultaneously. It may further be possible to perform one, more than one or even all of the method steps once or repeatedly. The method may comprise additional method steps that are not listed.

The method may specifically comprise using the monitoring device 112 according to the present invention, for example according to the embodiment described in Figure 1. However, other embodiments of the monitoring device 112 are feasible.

The method comprises in step i) (denoted by reference number 154): receiving 156 information on the at least one amount of acceleration energy required for accelerating the electric motor 114 from the at least one first motion state to the at least one second motion state. Specifically, step i) may be performed in the at least one receiving unit 116 of the monitoring device 112.

Further, the method comprises in step ii) (denoted by reference number 158): evaluating 160 the information on the amount of acceleration energy and determining 162 the at least one item of information on the wearing status of the electric motor 114. Specifically, step ii) may be performed in the at least one evaluation unit 122 of the monitoring device 112.

The method may be at least partially computer-implemented, wherein, specifically, step ii) may be at least partially computer-implemented. For example, method step ii) may be performed in the evaluation unit 122, specifically in the at least one processor 128 of the evaluation unit 122.

Further, step ii) of the method may comprise comparing the amount of acceleration energy, e.g. the information on the amount of acceleration energy or secondary information derived thereof, with at least one reference value (denoted by reference value 164). Specifically, step ii) may comprise comparing at least one of a quotient of the amount of acceleration energy and the reference value or a difference between the amount of acceleration energy and the reference value with at least one threshold value. The threshold value may be a value amounting to 20 % to 90 % of an initial amount of acceleration energy required for accelerating the electric motor 114 from the at least one first motion state to at least one initial motion state when the electric motor 114 was new, specifically a value amounting to 50 % to 80 % of the initial amount of acceleration energy, more specifically a value amounting to 70 % of the initial amount of acceleration energy. The initial amount of acceleration energy may specifically be an amount of acceleration energy required for accelerating the electric motor 114 during a first, initial motion. Further, the reference value may be a reference value selected from the group consisting of: a predetermined reference value; a reference value determined by using the initial amount of acceleration energy required for accelerating the electric motor 114 from the at least one first motion state to the at least one initial motion state when the electric motor 114 was new.

Further, the method may comprise, specifically in step ii), determining the at least one recommended action on the basis of the item of information on the wearing status and outputting the recommended action (denoted by reference number 166). Additionally or alternatively, the method may comprise, specifically in step ii), determining, on the basis of the item of information on the wearing status, if the warning state is given and if the warning state is given, outputting the warning (denoted by reference number 168).

Figure 4 shows a flow chart of an exemplary embodiment of a method of operating the laboratory system 110. The method comprises the following steps, which may specifically be performed in the given order. Still, a different order may also be possible. It may be possible to perform two or more of the method steps fully or partially simultaneously. It may further be possible to perform one, more than one or even all of the method steps once or repeatedly. The method may comprise additional method steps that are not listed.

The method comprises:
I. (denoted by reference number 170) manipulating at least one object by using the electric motor 114;
II. (denoted by reference number 172) monitoring the electric motor 114 by using the method of monitoring the electric motor 114 according to the present invention, for example according to the embodiment of Figure 3.

Step I. specifically may form part of a routine operation of the laboratory system 110. Additionally or alternatively, step I. may also be performed during a specific maintenance or test routine, such as a dedicated routine for testing the electric motor 114. Thus, the monitoring of the electric motor 114 in step II. may be performed during routine operation of the electric motor 114 and/or may be performed during a separate routine, such as a maintenance or test routine, wherein, in the first case, the electric motor 114 may be used for the laboratory task, whereas, in the second case, the electric motor 114 may be operated for test purposes. Other options are feasible.

The at least one object manipulated by the electric motor 114 specifically may be selected from the group consisting of at least one sample and at least one other component of the laboratory system 110. Thus, as an example, the at least one object manipulated by the electric motor 114 may be or may comprise at least one sample, such as at least one sample vessel containing the sample, e.g. at least one sample tube. Additionally or alternatively, the at least one object manipulated by the electric motor 114 may also comprise another component of the laboratory system 110, such as at least one linear stage and/or at least one rotating stage. Other objects are feasible. Specifically, the entire method or at least step II. may be performed at least once within a predetermined period of time. For example, the monitoring may be performed continuously, and intermittently or at least once within a predetermined or variable time span, such as within one day, one week, one month or any other period of time.

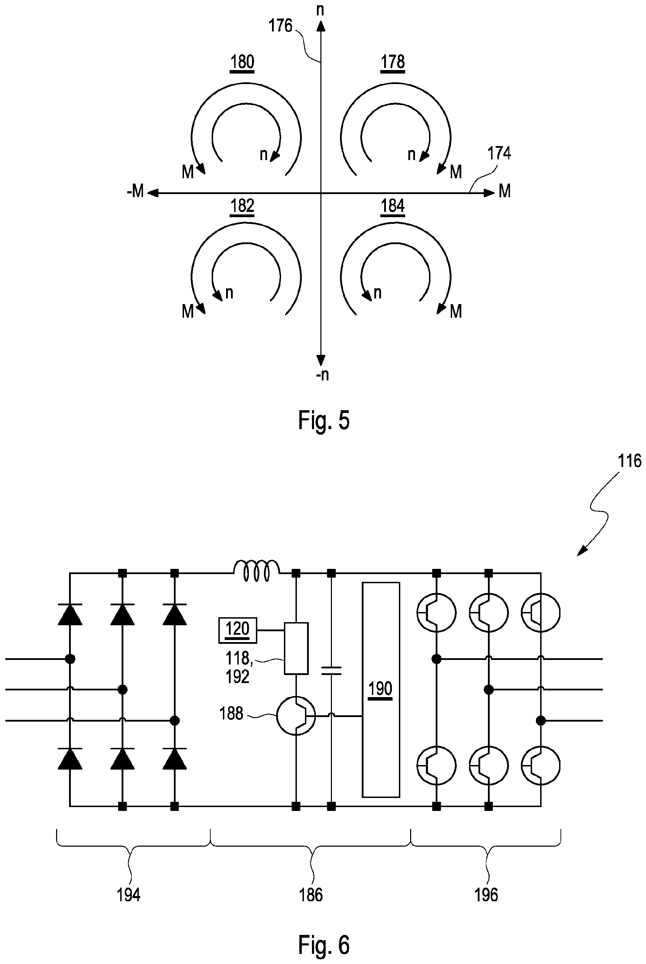

Figure 5 shows a diagram of operations modes of the electric motor 114. The diagram of Figure 5 shows a torque 174 applied to the electric motor 114 on a x-axis and a rotational speed 176 of the electric motor 114 on a y-axis of the diagram. As outlined in chapter 3.5 of "Wissenswertes über Frequenzumrichter", handbook on VLT^{®}-variable-frequency drives, published by Danfoss^{®}, electric motors 114 may, in general, be operated in at least one of a first operation mode 178, a second operation mode 180, a third operation mode 182 and a fourth operation mode 184. As shown in Figure 5, in the first operation mode 178, the torque 174 and the rotational speed 176 of the electric motor 114 may be positive and the electric motor 114 may be running in clockwise direction. Thus, the electric motor 114 may be accelerated in the first operation mode 178. In the second operation mode 180, the rotational speed 176 of the electric motor 114 may still be positive. However, the torque 174 applied to the electric motor 114 may be negative and, thus, may be opposite to the rotational speed 176. The electric motor 114 in the second operation mode 180 may still be running in clockwise direction but may be decelerated. In the third operation mode 182, both the torque 174 and the rotational speed 176 of the electric motor 114 may be negative. The electric motor 114 may be accelerated in counter-clockwise direction in the third operation mode 182. In the fourth operation mode 184, the torque 174 applied to the electric motor 114 may be positive and the rotational speed 176 may be negative. The electric motor 114 may be running in counter-clockwise direction and may be decelerated by the torque 174 being opposite to the rotational speed 176. The monitoring device 112 may specifically be configured for monitoring the electric motor 114 in the second 180 and/or the fourth operation mode 184, i.e. in an operation mode where the electric motor 114 is decelerated. The monitoring device 112, specifically the receiving unit 116, may be configured for receiving the amount of acceleration energy which is at least one of dissipated, recuperated or released when decelerating the electric motor 114 from a rotating motion state to a stationary state.

Figure 6 shows an exemplary embodiment of the receiving unit 116. In this example, the receiving unit 116 may comprise at least one brake chopper 186. The brake chopper may comprise at least one transistor 188, for example an insulated-gate bipolar transistor, and at least one control unit 190 for controlling a functionality of the brake chopper 186. The control unit 188 may be configured for controlling a chopping of a voltage and/or a current applied to the brake chopper 186. The chopped voltage and/or current may be passed to at least one resistor 192 comprised by the brake chopper 186. In the example of Figure 6, the resistor 192 may be the measurement resistor 118, wherein the measurement device 120 may be configured for monitoring at least one of a voltage, a current or a power at the measurement resistor 118. Additionally, as shown in Figure 6, the receiving unit 116 may comprise at least one rectifier 194 for converting an input AC voltage to a DC voltage and at least one inverter 196 for converting DC voltage to an output AC voltage.

### List of reference numbers

- 110: laboratory system
- 112: monitoring device
- 114: electric motor
- 116: receiving unit
- 118: measurement resistor
- 120: measurement device
- 121: measurement signal
- 122: evaluation unit
- 124: filtering device
- 126: low pass filter
- 128: processor
- 130: electronic switching element
- 132: H-bridge
- 134: energy source
- 136: controller
- 138: microcontroller
- 140: electronic switch
- 142: changeover switch
- 144: time
- 146: power
- 148: starting point of acceleration
- 150: amount of acceleration energy for a proper functioning electric motor
- 152: amount of acceleration energy for a malfunctioning electric motor
- 154: step i)
- 156: receiving information on the amount of acceleration energy
- 158: step ii)
- 160: evaluating information on the amount of acceleration energy
- 162: determining the item of information on the wearing status of the electric motor
- 164: comparing the amount of acceleration energy with at least one reference value
- 166: determining and outputting the recommended action
- 168: determining and outputting the warning
- 170: manipulating an object
- 172: monitoring the electric motor
- 174: torque
- 176: rotational speed
- 178: first operation mode
- 180: second operation mode
- 182: third operation mode
- 184: fourth operation mode
- 186: brake chopper
- 188: transistor
- 190: control unit
- 192: resistor
- 194: rectifier
- 196: inverter

## Claims

1. A monitoring device (112) for monitoring an electric motor (114), comprising:
A. at least one receiving unit (116) configured for receiving information on at least one amount of acceleration energy required for accelerating the electric motor (114) from at least one first motion state to at least one second motion state;
B. at least one evaluation unit (122) configured for evaluating the information on the amount of acceleration energy and for determining at least one item of information on a wearing status of the electric motor (114),
**characterized in that**
the amount of acceleration energy comprises an acceleration energy required for decelerating the electric motor (114), wherein the acceleration energy comprises an acceleration energy which is at least one of dissipated, recuperated or released when decelerating the electric motor (114) from a rotating motion state to a stationary state.

2. The monitoring device (112) according to the preceding claim, wherein the receiving unit (116) comprises at least one of a measurement resistor (118), a measurement capacitor and an energy buffer, wherein the receiving unit (116) further comprises at least one measurement device (120) configured for monitoring at least one of a voltage, a current or a power at the measurement resistor (118), the measurement capacitor or the energy buffer, respectively.

3. The monitoring device (112) according to the preceding claim, wherein the measurement device (120) is configured for generating at least one measurement signal (121) indicative of the voltage, the current or the power, respectively, as a function of time, wherein the monitoring device (112) further comprises at least one filtering device (124).

4. The monitoring device (112) according to any one of the preceding claims, wherein the evaluation unit (122) further comprises at least one processor (128) for determining the at least one item of information on the wearing status.

5. The monitoring device (112) according to any one of the preceding claims, wherein the evaluation unit (122) further is configured for determining at least one recommended action on the basis of the item of information on the wearing status.

6. The monitoring device (112) according to any one of the preceding claims, wherein the evaluation unit (122) further is configured, on the basis of the item of information on the wearing status, for determining if at least one warning state is given, wherein the evaluation unit (122) is configured, if the warning state is given, for outputting a warning.

7. A laboratory system (110) for performing at least one laboratory task, comprising at least one electric motor (114) and further comprising at least one monitoring device (112) according to any one of the preceding claims.

8. The laboratory system (110) according to the preceding claim, wherein the laboratory system (110) further comprises at least one electronic switching element (130), wherein the electronic switching element (130) is configured for at least one of reversing a polarity of a voltage applied to the electric motor (114) and negatively accelerating the electric motor (114).

9. The laboratory system (110) according to any one of the two preceding claims, further comprising at least one controller (136) for controlling the functionality of the electric motor (114), wherein the controller (136) comprises one or more processors (128).

10. A method of monitoring an electric motor (114), comprising:
i) receiving information on at least one amount of acceleration energy required for accelerating the electric motor (114) from at least one first motion state to at least one second motion state, wherein the amount of acceleration energy comprises an acceleration energy required for decelerating the electric motor (114), wherein the acceleration energy comprises an acceleration energy which is at least one of dissipated, recuperated or released when decelerating the electric motor (114) from a rotating motion state to a stationary state;
ii) evaluating the information on the amount of acceleration energy and determining at least one item of information on a wearing status of the electric motor (114).

11. The method according to the preceding claim, wherein the method is at least partially computer-implemented.

12. The method according to any one of the preceding method claims, wherein step ii) comprises comparing the amount of acceleration energy with at least one reference value.

13. The method according to the preceding claim, wherein step ii) comprises comparing at least one of a quotient of the amount of acceleration energy and the reference value or a difference between the amount of acceleration energy and the reference value with at least one threshold value.

14. A method of operating a laboratory system (110) for performing at least one laboratory task, comprising:
I. manipulating at least one object by using an electric motor (114);
II. monitoring the electric motor (114) by using the method according to any one of the preceding method claims.

## Patentansprüche

1. Überwachungsvorrichtung (112) zur Überwachung eines Elektromotors (114), umfassend:
A. mindestens eine Empfangseinheit (116), die zum Empfangen von Informationen zu mindestens einem Beschleunigungsenergiebetrag, der zum Beschleunigen des Elektromotors (114) aus mindestens einem ersten Bewegungszustand in mindestens einen zweiten Bewegungszustand erforderlich ist, ausgebildet ist;
B. mindestens eine Auswerteeinheit (122), die zum Auswerten der Informationen zu dem Beschleunigungsenergiebetrag und zum Bestimmen mindestens eines Informationsdetails zu einem Verschleißstatus des Elektromotors (114) ausgebildet ist,
**dadurch gekennzeichnet, dass**
der Beschleunigungsenergiebetrag eine Beschleunigungsenergie umfasst, die zum Verlangsamen des Elektromotors (114) erforderlich ist, wobei die Beschleunigungsenergie eine Beschleunigungsenergie umfasst, die mindestens eines von verbraucht, wiedergewonnen oder freigesetzt ist, wenn der Elektromotor (114) aus einem Drehbewegungszustand in einen stationären Zustand verlangsamt wird.

2. Überwachungsvorrichtung (112) nach dem vorstehenden Anspruch, wobei die Empfangseinheit (116) mindestens eines von einem Messwiderstand (118), einem Messkondensator und einem Energiepuffer umfasst, wobei die Empfangseinheit (116) ferner mindestens eine Messvorrichtung (120) umfasst, die zur Überwachung mindestens eines von Spannung, Strom oder Leistung an dem Messwiderstand (118), dem Messkondensator bzw. dem Energiepuffer ausgebildet ist.

3. Überwachungsvorrichtung (112) nach dem vorstehenden Anspruch, wobei die Messvorrichtung (120) zum Erzeugen mindestens eines Messsignals (121) ausgebildet ist, das die Spannung, den Strom bzw. die Leistung als eine Funktion der Zeit angibt, wobei die Überwachungsvorrichtung (112) ferner mindestens eine Filtervorrichtung (124) umfasst.

4. Überwachungsvorrichtung (112) nach einem der vorstehenden Ansprüche, wobei die Auswerteeinheit (122) ferner mindestens einen Prozessor (128) zum Bestimmen des mindestens einen Informationsdetails zum Verschleißstatus umfasst.

5. Überwachungsvorrichtung (112) nach einem der vorstehenden Ansprüche, wobei die Auswerteeinheit (122) ferner zum Bestimmen mindestens einer empfohlenen Handlung basierend auf dem Informationsdetail zum Verschleißstatus ausgebildet ist.

6. Überwachungsvorrichtung (112) nach einem der vorstehenden Ansprüche, wobei die Auswerteeinheit (122) basierend auf dem Informationsdetail zum Verschleißstatus ferner zum Bestimmen, ob mindestens ein Warnzustand gegeben ist, ausgebildet ist, wobei die Auswerteeinheit (122) zum Ausgeben einer Warnung ausgebildet ist, wenn der Warnzustand gegeben ist.

7. Laborsystem (110) zum Ausführen mindestens einer Laboraufgabe, umfassend mindestens einen Elektromotor (114) und ferner umfassend mindestens eine Überwachungsvorrichtung (112) nach einem der vorstehenden Ansprüche.

8. Laborsystem (110) nach dem vorstehenden Anspruch, wobei das Laborsystem (110) ferner mindestens ein elektronisches Schaltelement (130) umfasst, wobei das elektronische Schaltelement (130) für mindestens eines von Umkehren einer Polarität einer an den Elektromotor (114) angelegten Spannung und Negativbeschleunigen des Elektromotors (114) ausgebildet ist.

9. Laborsystem (110) nach einem der beiden vorstehenden Ansprüche, ferner umfassend mindestens eine Steuerung (136) zum Steuern der Funktionalität des Elektromotors (114), wobei die Steuerung (136) einen oder mehrere Prozessor(en) (128) umfasst.

10. Verfahren zur Überwachung eines Elektromotors (114), umfassend:
i) Empfangen von Informationen zu mindestens einem Beschleunigungsenergiebetrag, der zum Beschleunigen des Elektromotors (114) aus mindestens einem ersten Bewegungszustand in mindestens einen zweiten Bewegungszustand erforderlich ist, wobei der Beschleunigungsenergiebetrag eine Beschleunigungsenergie umfasst, die zum Verlangsamen des Elektromotors (114) erforderlich ist, wobei die Beschleunigungsenergie eine Beschleunigungsenergie umfasst, die mindestens eines von verbraucht, wiedergewonnen oder freigesetzt ist, wenn der Elektromotor (114) aus einem Drehbewegungszustand in einen stationären Zustand verlangsamt wird;
ii) Auswerten der Informationen zu dem Beschleunigungsenergiebetrag und Bestimmen mindestens eines Informationsdetails zu einem Verschleißstatus des Elektromotors (114).

11. Verfahren nach dem vorstehenden Anspruch, wobei das Verfahren mindestens teilweise computerimplementiert ist.

12. Verfahren nach einem der vorstehenden Verfahrensansprüche, wobei Schritt ii) das Vergleichen des Beschleunigungsenergiebetrages mit mindestens einem Referenzwert umfasst.

13. Verfahren nach dem vorstehenden Anspruch, wobei Schritt ii) das Vergleichen mindestens eines von einem Quotienten des Beschleunigungsenergiebetrages und des Referenzwertes oder einer Differenz zwischen dem Beschleunigungsenergiebetrag und dem Referenzwert mit mindestens einem Schwellenwert umfasst.

14. Verfahren zum Betreiben eines Laborsystems (110) zum Ausführen mindestens einer Laboraufgabe, umfassend:
I. Beeinflussen mindestens eines Objektes unter Verwendung eines Elektromotors (114);
II. Überwachen des Elektromotors (114) unter Verwendung des Verfahrens nach einem der vorstehenden Verfahrensansprüche.

## Revendications

1. Dispositif de surveillance (112) pour surveiller un moteur électrique (114), comprenant :
A. au moins une unité de réception (116) configurée pour recevoir des informations sur au moins une quantité d'énergie d'accélération exigée pour accélérer le moteur électrique (114) d'au moins un premier état de mouvement à au moins un second état de mouvement ;
B. au moins une unité d'évaluation (122) configurée pour évaluer les informations sur la quantité d'énergie d'accélération et pour déterminer au moins un élément d'information sur un statut d'usure du moteur électrique (114),
**caractérisé en ce que**
la quantité d'énergie d'accélération comprend une énergie d'accélération exigée pour décélérer le moteur électrique (114), dans lequel l'énergie d'accélération comprend une énergie d'accélération qui est au moins une parmi dissipée, récupérée ou libérée lors de la décélération du moteur électrique (114) d'un état de mouvement rotatif à un état stationnaire.

2. Dispositif de surveillance (112) selon la revendication précédente, dans lequel l'unité de réception (116) comprend au moins un parmi une résistance de mesure (118), un condensateur de mesure et un tampon d'énergie, dans lequel l'unité de réception (116) comprend en outre au moins un dispositif de mesure (120) configuré pour surveiller au moins un parmi une tension, un courant ou une puissance au niveau de la résistance de mesure (118), du condensateur de mesure ou du tampon d'énergie, respectivement.

3. Dispositif de surveillance (112) selon la revendication précédente, dans lequel le dispositif de mesure (120) est configuré pour générer au moins un signal de mesure (121) indiquant la tension, le courant ou la puissance, respectivement, en fonction du temps, dans lequel le dispositif de surveillance (112) comprend en outre au moins un dispositif de filtration (124).

4. Dispositif de surveillance (112) selon l'une quelconque des revendications précédentes, dans lequel l'unité d'évaluation (122) comprend en outre au moins un processeur (128) pour déterminer l'au moins un élément d'information sur le statut d'usure.

5. Dispositif de surveillance (112) selon l'une quelconque des revendications précédentes, dans lequel l'unité d'évaluation (122) est en outre configurée pour déterminer au moins une action recommandée sur la base de l'élément d'information sur le statut d'usure.

6. Dispositif de surveillance (112) selon l'une quelconque des revendications précédentes, dans lequel l'unité d'évaluation (122) est en outre configurée, sur la base de l'élément d'information sur le statut d'usure, pour déterminer si au moins un état d'avertissement est donné, dans lequel l'unité d'évaluation (122) est configurée, si l'état d'avertissement est donné, pour émettre un avertissement.

7. Système de laboratoire (110) pour réaliser au moins une tâche de laboratoire, comprenant au moins un moteur électrique (114) et comprenant en outre au moins un dispositif de surveillance (112) selon l'une quelconque des revendications précédentes.

8. Système de laboratoire (110) selon la revendication précédente, dans lequel le système de laboratoire (110) comprend en outre au moins un élément de commutation électronique (130), dans lequel l'élément de commutation électronique (130) est configuré pour au moins une parmi une inversion d'une polarité d'une tension appliquée au moteur électrique (114) et une accélération négative du moteur électrique (114).

9. Système de laboratoire (110) selon l'une quelconque des deux revendications précédentes, comprenant en outre au moins un dispositif de commande (136) pour commander la fonctionnalité du moteur électrique (114), dans lequel le dispositif de commande (136) comprend un ou plusieurs processeurs (128).

10. Procédé de surveillance d'un moteur électrique (114), comprenant :
i) la réception d'informations sur au moins une quantité d'énergie d'accélération exigée pour accélérer le moteur électrique (114) d'au moins un premier état de mouvement à au moins un second état de mouvement, la quantité d'énergie d'accélération comprenant une énergie d'accélération exigée pour décélérer le moteur électrique (114), l'énergie d'accélération comprenant une énergie d'accélération qui est au moins une parmi dissipée, récupérée ou libérée lors de la décélération du moteur électrique (114) d'un état de mouvement rotatif à un état stationnaire ;
ii) l'évaluation des informations sur la quantité d'énergie d'accélération et la détermination d'au moins un élément d'information sur un statut d'usure du moteur électrique (114).

11. Procédé selon la revendication précédente, dans lequel le procédé est au moins partiellement mis en oeuvre par ordinateur.

12. Procédé selon l'une quelconque des revendications de procédé précédentes, dans lequel l'étape ii) comprend la comparaison de la quantité d'énergie d'accélération avec au moins une valeur de référence.

13. Procédé selon la revendication précédente, dans lequel l'étape ii) comprend la comparaison d'au moins un parmi un quotient de la quantité d'énergie d'accélération et de la valeur de référence ou une différence entre la quantité d'énergie d'accélération et la valeur de référence avec au moins une valeur seuil.

14. Procédé de fonctionnement d'un système de laboratoire (110) pour réaliser au moins une tâche de laboratoire, comprenant :
I. la manipulation d'au moins un objet en utilisant un moteur électrique (114) ;
II. la surveillance du moteur électrique (114) en utilisant le procédé selon l'une quelconque des revendications de procédé précédentes.
